# FASCICULE DE BREVET EUROPEEN

(11) **EP 1 570 516 B1**
(45) Date de publication et mention de la délivrance du brevet: **03.05.2006**
(21) Numéro de dépôt: 03815088.4
(22) Date de dépôt: 08.12.2003
(51) Int. Cl.: H01L 21/762, H01L 21/304, H01L 21/20

(54) **PROCEDE DE REALISATION D'UNE STRUCTURE CONTRAINTE DESTINEE A ETRE DISSOCIEE**
VERFAHREN ZUR HERSTELLUNG EINER FÜR DISSOZIATION AUSGELEGTEN BELASTETEN STRUKTUR
METHOD FOR MAKING A STRESSED STRUCTURE DESIGNED TO BE DISSOCIATED

(30) Priorité: 09.12.2002 FR 0215550
(43) Date de publication de la demande: 07.09.2005
(73) Titulaire: COMMISSARIAT A L'ENERGIE ATOMIQUE, 75752 Paris Cédex 15 (FR)
(72) Inventeur: FOURNEL, Franck, F-38430 Moirans (FR); MORICEAU, Hubert, F-38120 Saint-Egreve (FR); LAGAHE, Christelle, 38134 Saint Joseph de Rivière (FR)
(74) Mandataire: Quantin, Bruno Marie Henri
(86) Numéro de dépôt international: PCT/FR2003/003622
(87) Numéro de publication internationale: WO 2004/064146

(56) Documents cités:
- EP-A- 0 410 679
- EP-A- 1 050 901
- WO-A-00/48238
- US-A- 4 254 590
- US-A- 5 400 548
- PATENT ABSTRACTS OF JAPAN vol. 013, no. 173 (E-748), 24 avril 1989 (1989-04-24) & JP 01 004013 A (SONY CORP), 9 janvier 1989 (1989-01-09)

## Description

L'invention concerne un procédé de réalisation d'une structure microélectronique complexe par assemblage de deux structures microélectroniques élémentaires, cette structure complexe étant destinée à être dissociée. Dans ce qui suit, la notion de structure microélectronique devra être considérée comme couvrant également les structures optoélectoniques, microtechnologiques, ou nanotechnologiques ou encore nanoélectroniques.

Le report d'une couche d'un substrat d'origine vers un substrat cible définitif ou temporaire est de plus en plus utilisé en microélectronique. Cette technique a, en effet, de multiples applications dont on ne citera ici que deux exemples à titre indicatif mais nullement limitatif. Elle est utilisée par exemple pour la réalisation de substrats de type SOI (silicium sur isolant) qui permettent en particulier la réalisation de composants rapides et de faible consommation. Elle est utilisée également pour la réalisation de substrats composites permettant de limiter les coûts en évitant l'utilisation de substrats massifs onéreux. C'est le cas par exemple des substrats massifs en carbure de silicium.

Un procédé connu permettant le report d'une couche mince d'un substrat source vers un substrat cible est décrit entre autre dans les documents FR 2 681 472 et ses différents perfectionnements (incorporés par référence). Il comprend notamment les étapes suivantes :
- création par implantation ionique d'une zone fragilisée enterrée au sein du substrat source délimitant au sein de ce substrat la couche mince à transférer,
- assemblage du substrat source avec le substrat cible au niveau de la surface libre de la couche mince,
- apport d'énergie thermique et/ou mécanique pour provoquer une fracture au sein du substrat source au niveau de la zone fragilisée.

Un problème peut se poser lorsque l'on souhaite utiliser un traitement thermique pour induire tout ou partie de la fracture au niveau de la zone fragilisée et que les substrats source et cible présentent des matériaux de coefficients de dilatation thermique très différents. C'est le cas par exemple si l'on souhaite transférer un film de silicium sur un substrat de silice fondue. En effet, le traitement thermique peut induire au sein de la structure formée par l'assemblage des deux substrats, du fait de la différence de coefficients de dilatation thermique, des contraintes internes importantes qui peuvent être dommageables pour la structure. Ces contraintes peuvent également être dommageables au moment de la fracture proprement dite, puisque, à ce moment là, les structures, en se dissociant brutalement, se relaxent immédiatement. Il y a donc, à ce moment, un saut de contraintes brutal au niveau de chaque structure, celle formée de la couche mince transférée solidaire du substrat cible et celle formée par le reste du substrat source. Ce saut, s'il est trop important, peut endommager au moins une de ces deux structures.

Pour résoudre ce problème, il faudrait être capable de contrôler de façon précise, à la température de fracture, les contraintes au sein de la structure formée de l'assemblage des deux substrats pour pouvoir les maintenir sous un niveau de contraintes acceptable, voire les minimiser.

Plus généralement, le problème est de contrôler les contraintes au sein d'une hétérostructure (structure complexe pouvant être formée par assemblage d'au moins deux matériaux différents) au moment de la dissociation de cette hétérostructure lorsque cette dissociation nécessite un changement de température.

### Exposé de l'invention

Pour répondre au problème posé, l'invention propose un procédé de réalisation d'une structure complexe par assemblage de deux substrats par deux faces respectives de liaison, cette structure étant destinée à être dissociée au niveau d'une zone de séparation, qui se caractérise par le fait que, avant assemblage, on crée une différence d'état de contraintes tangentielles entre les deux faces à assembler en courbant chacun des deux substrats à assembler par application de forces mécaniques, cette différence étant choisie en sorte d'obtenir au sein de la structure assemblée un état de contraintes prédéterminé au moment de la dissociation.

Avantageusement, la différence d'état de contraintes tangentielles entre les deux faces à assembler est choisie en sorte de minimiser les contraintes au niveau de la zone de séparation au moment de la dissociation.

Ainsi, l'invention préconise de générer volontairement des contraintes dans la structure assemblée pour lui permettre de compenser les contraintes qui seront générées par la suite lors de l'élévation en température nécessaire à la dissociation de la structure.

Il est à noter que, dans un tout autre contexte, il est proposé dans la publication de D. Feijoo, I. Ong, K. Mitani, W. S. Yang, S. Yu and U. M. Gösele, "Prestressing of bonded wafers", Proceedings of the 1st international symposium on semiconductor wafer bonding, Science, Technology and applications, Vol. 92-7, The Electrochemical Society (1992) p.230, une méthode pour générer des contraintes internes au sein d'une structure complexe pour renforcer la stabilité mécanique de cette structure.

Pour cela, deux structures, en l'occurrence deux plaques de silicium, sont collées par adhésion moléculaire dans des conditions standard. La structure complexe ainsi formée est ensuite contrainte par courbure. La courbure est provoquée par l'application d'un pointeau au centre de la structure, la structure étant maintenue fixe en sa périphérie. En courbant suffisamment la structure, l'interface de collage cède : les deux plaques se décollent puis se recollent aussitôt à la courbure atteinte. Ce processus de décollement/recollement peut s'opérer plusieurs fois en fonction de l'énergie de collage à l'interface et de la force appliquée grâce au pointeau. Lorsque les auteurs relâchent la contrainte due au pointeau, la structure complexe se relaxe et se stabilise à un rayon de courbure qui dépend de celui obtenu lors du dernier décollement/recollement de la structure complexe sous contrainte du pointeau. Des contraintes internes sont ainsi générées dans la structure complexe.

Mais ces contraintes internes générées dans la structure ne sont pas facilement ajustables par cette technique. En effet, elles sont dépendantes des valeurs relatives de l'énergie de déformation élastique de la structure et de l'énergie du collage. De plus, comme l'indique les auteurs, cette méthode ne peut être employée pour des collages moléculaires de trop forte énergie car dans ces conditions, les deux structures assemblées ne parviennent pas à se décoller et, si on reste dans les limites de déformation élastique de la structure quand on retire le pointeau, la structure revient à son état initial au moment du collage moléculaire. Celle-ci ne présente alors aucune courbure et donc aucune contrainte interne. Or, il est souvent technologiquement intéressant d'avoir une forte énergie de collage afin d'assurer par exemple une bonne solidité de l'interface de collage.

Ce document ne se préoccupe nulle part de contrôler les contraintes au sein de la structure liées à un changement de température.

La technique décrite dans ce document permet donc certes de générer des contraintes dans une structure complexe mais n'associe pas cette idée à la résolution de problèmes de comportement en température d'une hétérostructure. Ce n'est donc qu'a posteriori que ce document peut présenter des analogies avec l'invention. En tout état de cause, la technique proposée est difficilement ajustable ce qui ne permet pas de réel contrôle des contraintes. Elle reste de plus limitée à des structures assemblées avec des énergies de collage limitées.

Le procédé de l'invention ne présente pas ces limitations. L'état de contraintes généré au sein de la structure complexe dépend des contraintes générées indépendamment avant assemblage, dans chaque substrat. Ces contraintes, voir ci-dessous, sont précisément ajustables. Le procédé est donc reproductible et ajustable de façon précise, ce qui permet de contrôler (ou maîtriser) les contraintes en fonction des besoins futurs. Les forces de collage entre les substrats à assembler ne sont plus limitées puisque la structure complexe n'a pas dans le cadre de l'invention à se décoller au cours de l'assemblage.

Dans la suite du document, les substrats à assembler sont également appelés structures élémentaires par opposition à la structure complexe formée par l'assemblage de ces deux substrats.

La différence de contraintes tangentielles entre les faces à coller des deux structures élémentaires peut avantageusement être créée en déformant (principalement de façon élastique) chacune des dites structures avant assemblage. Une technique simple et facile à mettre en oeuvre pour générer des contraintes est de courber ces structures.

Selon un mode de réalisation préféré, les deux structures élémentaires seront courbées de sorte que les deux faces à assembler sont respectivement concave et convexe. Elles peuvent par ailleurs être complémentaires, par exemple respectivement sphérique concave et sphérique convexe.

Courber les structures élémentaires pour générer des contraintes peut, par exemple, être mis en oeuvre par application de forces mécaniques localisées et/ou réparties sur les structures à déformer.

Selon un mode de réalisation préféré, on peut créer une différence de pression entre les deux faces de la structure à courber. Parmi les moyens de réaliser cette différence de pression pour obtenir une structure élémentaire présentant une face à assembler concave, on peut citer l'aspiration de ladite structure sur une préforme concave de profil adapté choisi en fonction de celui à donner à la face à assembler et sur laquelle la structure repose localement en sa périphérie. Avantageusement, on pourra prévoir des joints pour améliorer l'étanchéité entre la structure et la préforme. On peut citer également l'aspiration de ladite structure à l'intérieur d'une cavité (sans préforme), la structure reposant localement en sa périphérie sur un joint bordant cette cavité.

La structure élémentaire courbée peut être obtenue par déformation de cette structure entre deux préformes complémentaires, l'une concave, l'autre convexe, de profils choisis en fonction de celui à donner à la face à assembler. Dans ce cas, il peut être prévu sur la préforme qui reçoit la structure élémentaire des canaux d'aspiration pour maintenir la structure courbée, une fois enlevée l'autre préforme. Cette autre préforme peut avantageusement être l'autre structure élémentaire à assembler déjà courbée selon le profil désiré.

Une autre alternative consiste à appliquer les forces mécaniques simultanément sur les deux structures à assembler, par exemple par déformation des deux structures entre deux préformes de profils choisis en fonction de ceux à donner aux faces à assembler.

De manière préférée :
- l'application de forces mécaniques sur l'un au moins des substrats est effectuée à l'aide d'une préforme constituée d'un moule,
- cette préforme est constituée d'un moule poreux,
- l'application de forces mécaniques sur les substrats est effectuée à l'aide d'au moins une préforme déformable.

De manière préférentielle, l'assemblage entre les deux structures est un collage moléculaire permettant d'atteindre des forces d'adhésion importantes et une interface de bonne qualité. Dans ce cas, avant ou après création de la différence d'état de contraintes entre les deux faces à assembler, lesdites faces sont traitées afin de faciliter le collage ultérieur. Ces traitements peuvent consister par exemple en un polissage mécanique et /ou chimique, un traitement chimique, un traitement UV ozone, RIE (reactive ion etching), plasma, un recuit hydrogène, etc.

Selon d'autres dispositions préférées de l'invention :
- l'assemblage entre les substrats est réalisé par contact direct, la surface d'au moins l'un des substrats étant aménagée en sorte d'éviter un piégeage d'air entre les surfaces assemblées,
- l'un au moins des substrats est percé,
- ce substrat est percé en son centre,
- l'un au moins des substrats comporte au moins un canal non traversant débouchant en bordure du substrat,
- l'assemblage entre les substrats est réalisé au moyen d'une couche de fluage,
- on réalise l'assemblage à une température supérieure à l'ambiante,
- les substrats sont chauffés par contact avec des préformes chauffées,
- les préformes sont respectivement chauffées à des températures différentes.

Par ailleurs, la différence d'état de contraintes tangentielles entre les deux faces à assembler est avantageusement choisie de sorte que les précontraintes ainsi créées au sein de la structure complexe permettent d'imposer pour la suite des contraintes internes spécifiées à une température spécifiée. Avantageusement, les précontraintes seront choisies pour minimiser ou annuler les contraintes au sein de la structure complexe.

L'invention concerne également un procédé de report d'une couche mince depuis un substrat source vers un substrat cible, comprenant les étapes suivantes :
- implantation ionique au travers d'une face du substrat source pour créer une couche fragilisée enterrée à une profondeur déterminée par rapport à la face implantée du substrat source, une couche mince étant ainsi délimitée entre la face implantée et la couche enterrée,
- assemblage d'une face du substrat source sur une face du substrat cible pour former une structure assemblée,
- dissociation de la couche mince d'avec le reste du substrat source au niveau de la couche enterrée,
ce procédé se caractérisant par le fait que, avant assemblage, on crée une différence d'état de contraintes tangentielles entre les deux faces à assembler, cette différence étant choisie en sorte d'obtenir au sein de la structure assemblée un état de contraintes prédéterminé au moment de la dissociation.

Avantageusement, cette différence d'état de contraintes tangentielles entre les deux faces à assembler est choisie en sorte de minimiser les contraintes au niveau de la couche enterrée au moment de la dissociation. Ceci permet de garantir la qualité des structures obtenue après dissociation.

Selon un mode préféré de réalisation, la différence d'état de contraintes tangentielles entre les deux faces à assembler est imposée en courbant, avant assemblage, chacun des deux substrats à assembler.

D'autres aspects et avantages de l'invention apparaîtront à la lecture de la description détaillée, que l'on trouvera ci-dessous, de modes particuliers de réalisation donnés à titre d'exemples non limitatifs. Cette description se réfère aux dessins annexés dans lesquels :
- la figure 1 est un graphique illustrant l'évolution des contraintes avec la température aux surfaces du substrat de silice fondue au sein d'une hétérostructure (silice + silicium) classique,
- la figure 2 est un graphique analogue illustrant les contraintes aux surfaces du substrat de silicium de cette hétérostructure,
- la figure 3 est un schéma d'une hétérostructure obtenue par le procédé de l'invention,
- les figures 4 et 5 sont des graphiques analogues à ceux des figures 1 et 2 illustrant l'évolution des contraintes avec la température au sein d'une hétérostructure contrainte selon le procédé de l'invention,
- la figure 6 illustre schématiquement un exemple de mise en oeuvre, non limitatif, du procédé selon l'invention,
- les figures 7, 8 et 9 illustrent des variantes de mises sous contraintes des structures élémentaires à assembler,
- les figures 10A et 10B représentent en vue de dessus deux exemples de réalisation de l'une des structures à assembler en vue d'éviter un piégeage de bulles d'air, et
- la figure 11 est une vue schématique en coupe d'un couple de deux préformes déformables.

### Description détaillée de modes de réalisation de l'invention

Sur les figures auxquelles se réfère la description qui suit, des parties identiques, similaires ou équivalentes sont repérées avec les mêmes références numériques. Par ailleurs pour des raisons de clarté des figures, les différents éléments ne sont pas représentés selon une échelle homogène.

Pour illustrer l'invention, nous allons décrire, à titre d'exemple non limitatif, le procédé de report d'un film, composé d'une couche de silicium d'environ 0.4µm et d'une couche d'oxyde d'environ 0,4µm à partir d'un substrat source en silicium oxydé en surface de 200mm de diamètre et 750µm d'épaisseur, sur un substrat cible de silice fondue de 200mm de diamètre et de 1200µm d'épaisseur.

Suivant les techniques classiques de report, ce film peut être transféré selon le procédé suivant :
- implantation ionique dans le substrat source de façon à créer au sein de ce substrat, une zone fragilisée qui délimite la couche mince à transférer dans des conditions d'implantation connues de l'homme du métier par exemple, implantation d'hydrogène à une dose d'environ 6,10¹⁶ H⁺/cm² sous une énergie de 75keV),
- collage par adhésion moléculaire de la couche oxydée du substrat source sur le substrat cible,
- transfert du film mince par fracture du substrat source au niveau de la zone fragilisée, cette fracture étant induite par exemple par un traitement thermique à environ 400°C, pouvant avantageusement être accompagné de l'application de forces mécaniques.

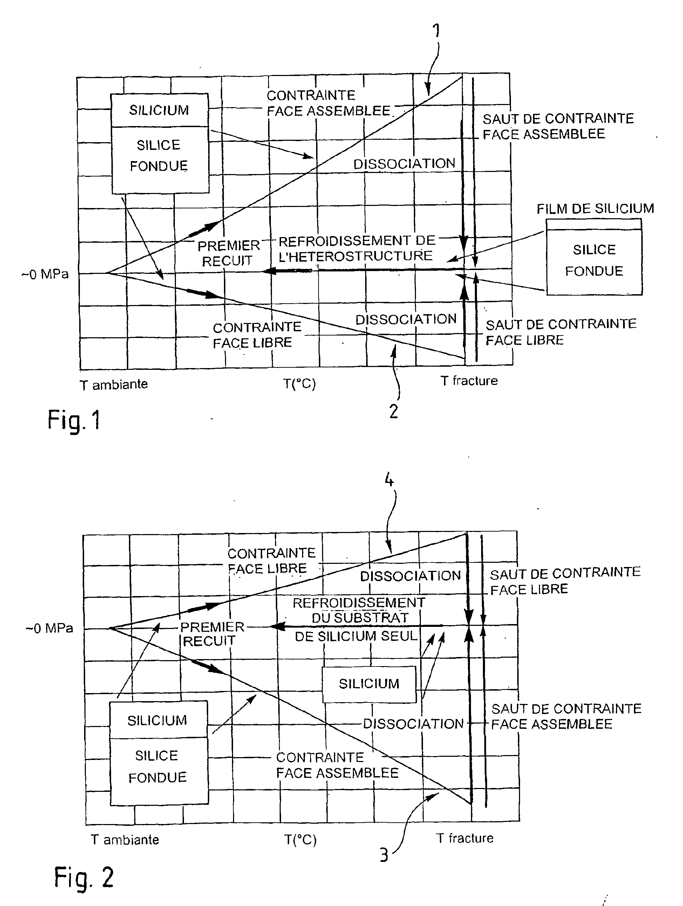

Les figures 1 et 2 illustrent respectivement les contraintes obtenues par calcul qui sont générées respectivement en surface des substrats de silice fondue et de silicium lors du traitement thermique dans la structure complexe classique formée de l'assemblage de ces deux substrats. A température ambiante, les deux substrats sont relaxés, il n'y a pas de contrainte interne au sein de la structure complexe.

Ensuite, avec l'élévation de la température, la structure est progressivement contrainte : la courbe 1 de la figure 1 illustre l'évolution de ces contraintes sur la face assemblée du substrat de silice fondue, la courbe 2 sur sa face libre, la courbe 3 de la figure 2 illustre l'évolution de ces contraintes en tension sur la face assemblée du substrat de silicium, la courbe 4 sur sa face libre.

Cette évolution des contraintes avec la température est parfaitement connue et quantifiable par l'homme du métier. Elle est décrite dans les documents suivants : S. Timoshenko, J. Opt. Soc. Am. 11 (1925) p.233 et D. Feijoo, l. Ong, K. Mitani, W. S. Yang, S. Yu and U. M. Gösele, Zhe-Chuan Feng and Hong-du Liu J; Appl. Phys. 54(1), 1983, p.83 "Generalized formula for curvature radius and layer stresses caused by thermal strain in semiconductor multilayer structures." En première approximation par des calculs de mécanique en théorie élastique continue, si on considère les matériaux isotropes et les coefficients de dilatation thermique constants sur la plage de température à couvrir, l'évolution des contraintes est approximativement linéaire avec la température. Des calculs plus complexes (par exemple par éléments finis) permettent d'affiner les résultats.

Le silicium ayant un coefficient de dilatation thermique plus élevé que celui de la silice fondue, lorsque la température s'élève, la face assemblée du silicium est gênée dans son expansion par la silice fondue, qui se dilate moins que le silicium. Cette face est donc contrainte en compression, provoquant du fait de sa raideur, la dilatation de sa face libre. Parallèlement, la face assemblée de la silice fondue est dilatée par le silicium entraînant du fait de la raideur de la silice fondue, la compression de sa face libre.

Au moment de la fracture, il y a brusque relâchement de ces contraintes. Ce relâchement correspond à un saut d'environ 100MPa au niveau de la zone de fracture pour le substrat de silicium, de 160MPa pour la face assemblée de la silice fondue.

Ces sauts de contraintes peuvent, s'ils ne sont pas contrôlés, endommager les structures obtenues.

Par contre, selon l'invention, on génère des pré-contraintes internes au sein de la structure de sorte qu'au moment de la fracture de la structure complexe assemblée, les contraintes soient imposées et avantageusement inférieures à un seuil permettant de garantir la qualité des structures obtenues après fracture.

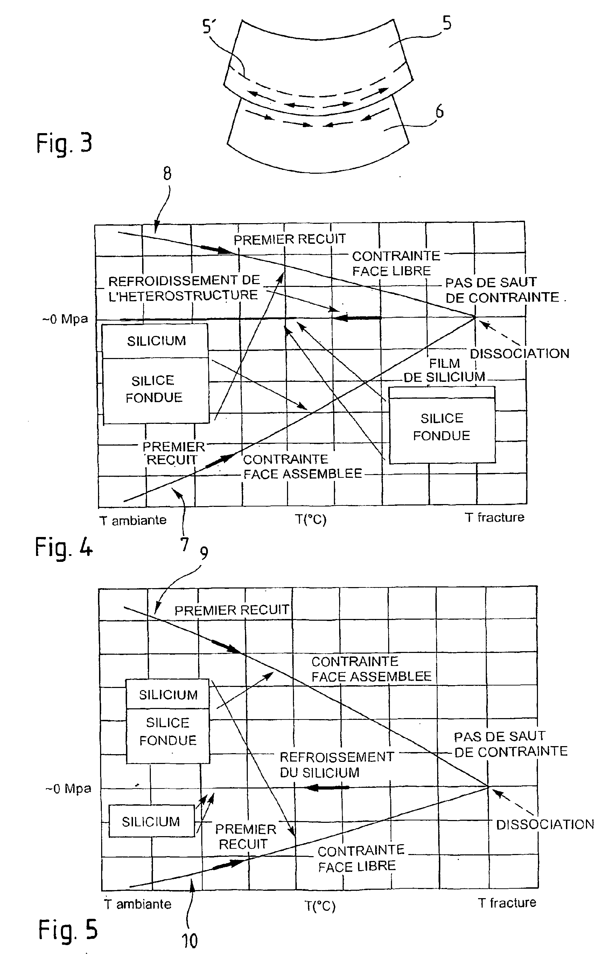

Ainsi, si on courbe avant assemblage le substrat source de silicium 5 et le substrat cible de silice fondue 6 avec un rayon de courbure au niveau des faces à assembler de l'ordre de 1.2m de sorte que la face à assembler du substrat de silicium 5 soit convexe et celle du substrat de silice fondue 6 soit concave, on obtient, après assemblage, la structure illustrée figure 3, avec au niveau de l'interface de collage un niveau de contraintes tangentielles données, la face assemblée du silicium étant, à température ambiante, contrainte en traction, celle de la silice fondue en compression. Les flèches, figure 3, symbolisent cet état de contrainte à l'interface de collage. La ligne 5' schématise une couche de fragilisation qui a été préalablement réalisée par implantation.

Ainsi contrainte, la structure complexe voit son niveau de contraintes évoluer avec la température comme illustré figure 4 respectivement pour la face assemblée (courbe 7) de la silice fondue et sa face libre (courbe 8) et figure 5 respectivement pour la face assemblée (courbe 9) du silicium et sa face libre (courbe 10).

On peut constater qu'à la température de fracture, il n'y a pratiquement plus de contrainte interne au sein de la structure complexe assemblée, ni au sein du substrat de silicium, ni au sein du substrat de silice fondue. Il n'y a donc plus de saut de contrainte au moment de la dissociation.

Dans cet exemple, les contraintes internes au niveau de la zone de fracture ayant été minimisées à la température de fracture, ces contraintes n'interviennent plus dans le mécanisme de fracture. Cela peut n'avoir qu'une influence négligeable sur le budget thermique (couple température-durée) nécessaire à la fracture et dans ce cas, on conservera le même budget thermique. Dans certains cas, Il pourra être nécessaire, par exemple, de modifier le temps de traitement thermique pour que la fracture s'effectue, par rapport au temps nécessaire pour la fracture dans le cas d'un collage sans précontrainte. On pourra également choisir, si on ne souhaite pas modifier le temps de traitement thermique, de changer la température de traitement thermique. On pourra alors avantageusement choisir un rayon de courbure avant collage adapté à cette nouvelle température. Il peut, par ailleurs, être intéressant de réduire, mais sans les minimiser, les contraintes internes au sein de la structure assemblée. C'est le cas par exemple, si on souhaite choisir le budget thermique nécessaire à la fracture tout en garantissant la qualité des structures obtenues après fracture. On peut bien sûr choisir d'appliquer des contraintes d'origine externe (traction, torsion,...) généralisées ou localisées.

Générer une différence de contraintes tangentielles entre les faces assemblées des deux substrats source et cible permet donc de limiter les sauts de contrainte subis par les différentes structures obtenues au moment de la dissociation de la structure assemblée. Avantageusement, si les deux substrats à assembler sont massifs et présentent des coefficients de dilatation thermique différents, la différence d'état de contraintes tangentielles entre les deux faces à assembler sera choisie de sorte que la face du substrat présentant le plus faible coefficient de dilatation thermique soit contrainte en compression par rapport à l'autre face à assembler. Les précontraintes ainsi créées au sein de la structure complexe viendront donc bien compenser par avance tout ou partie des contraintes à venir, liées à l'élévation de température, en particulier à la température de dissociation.

Compte-tenu de la température choisie pour la dissociation et des coefficients de dilatation des matériaux en cause, il est à la portée de l'homme de métier de déterminer les contraintes à générer lors de l'assemblage.

Il existe bien des manières de générer cette différence d'état de contraintes.

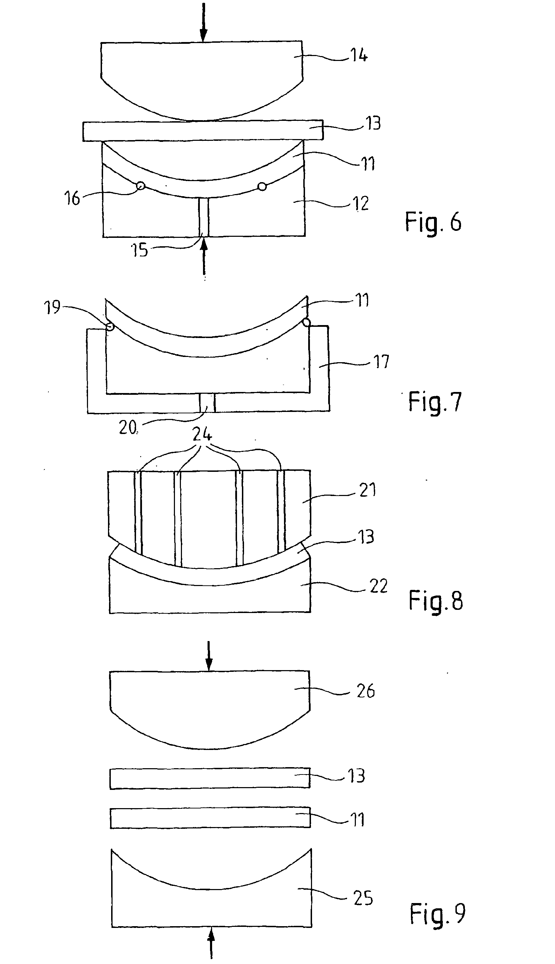

La figure 6 illustre un exemple de procédé. Une première structure élémentaire 11 est déformée par aspiration sur une première préforme 12 de forme spécifique, par exemple sphérique concave. L'aspiration est réalisée grâce à des canaux d'aspiration 15 débouchant à la surface de la préforme. Des joints 16 situés en périphérie de préforme peuvent soutenir la première structure 11 et permettre d'assurer une différence de pression entre les deux faces de cette structure. Celle-ci sous l'effet de cette différence de pression se déforme pour épouser la forme de la première préforme 12. Du fait de la déformation, des contraintes connues et quantifiables par l'homme du métier naissent au sein de la première structure 11 et en particulier sur sa face libre (supérieure).

Une deuxième structure 13 est alors mise en regard de la face libre de la première structure 11. Une deuxième préforme 14, de forme adaptée et avantageusement complémentaire de la forme de la première préforme 12, par exemple sphérique convexe, est prévue pour assurer la déformation élastique de la deuxième structure 13 entre la deuxième préforme 14 et la première structure 11. La flèche représentée sur la figure 6 symbolise l'application des forces destinées à réaliser la déformation proprement dite. Au cours de cette déformation, la deuxième structure 13 se déforme progressivement au contact de la première structure 11 jusqu'à en épouser la forme.

Les deux faces à assembler ayant ici été conditionnées, par exemple avant la mise sous contrainte des deux structures, de façon connue de l'homme du métier, afin de permettre un collage par adhésion moléculaire, ce collage s'effectue lorsque les deux faces en regard coïncident.

On obtient alors une structure complexe du type de celle de la figure 3, formée de l'assemblage de deux structures élémentaires contraintes présentant au niveau de leurs faces assemblées une différence de contraintes tangentielles connue et imposée par la déformation respective des deux structures avant le collage.

Il est à la portée de l'homme du métier de relier précisément la déformation imposée sur les structures avec le niveau de contraintes obtenues dans la structure et en particulier celui obtenu sur la face à assembler. Il sait donc par un choix adapté de la forme des préformes 12 et 14 imposer précisément une différence de contraintes tangentielles entre les deux faces à assembler avant le collage et donc imposer les contraintes en tout point de la structure complexe une fois assemblée. Les préformes peuvent être par exemple des moules rigides, des moules poreux ou encore des membranes déformables...

Une variante du procédé consiste, comme illustré figure 7, à remplacer la première préforme 12 par un dispositif creux 17 muni d'une cavité centrale 18. La première structure 11 repose alors sur ce dispositif en sa périphérie par l'intermédiaire de joints étanches 19. Des canaux d'aspiration 20 permettent de créer dans la cavité une dépression. En ajustant la différence de pression qui s'applique entre les deux faces de la première structure 11, on peut ainsi déformer cette première structure 11 selon une courbure déterminée. Par exemple, pour un vide dans la cavité d'environ 25 kPa (0.25 bar), l'autre face de la structure étant soumise à la pression atmosphérique, on obtient 3 mm de flèche sur une plaque de 200 mm de diamètre standard de silicium d'épaisseur 750 micromètres avec un joint de diamètre 195mm. La première structure 11 peut ensuite être assemblée à la seconde structure 3 comme expliqué précédemment.

Une autre variante est illustrée sur la figure 8. Elle consiste à réaliser la déformation de la seconde structure 13 entre deux préformes adaptées de formes complémentaires, l'une concave 22 et l'autre convexe 21. La préforme convexe est munie de canaux d'aspiration 24 pour permettre de maintenir la deuxième structure 13 dans sa position après la déformation et le retrait de la préforme concave 22. La deuxième structure 13 peut ensuite être assemblée à la première structure 11 elle-même déjà déformée (par exemple conformément à la figure 7), par un collage à l'aide d'une colle par exemple.

Une autre variante consiste à assembler sans contrainte à température ambiante les deux structures élémentaires à assembler par un collage moléculaire. On déforme ensuite cette structure assemblée entre deux moules complémentaires. On s'assure ensuite que chacune des structures est solidaire d'un des moules (par aspiration par exemple) puis on provoque par tout moyen connu de l'homme du métier une séparation de la structure assemblée au niveau de la zone de collage moléculaire. On obtient alors deux structures élémentaires contraintes que l'on peut ensuite assembler selon l'invention. Cette variante a pour avantage de préserver l'état de surface au niveau des faces à assembler, permettant ainsi par exemple, d'assembler les deux structures élémentaires contraintes par un nouveau collage moléculaire.

L'assemblage des deux structures élémentaires peut donc être un collage par adhésion moléculaire ou encore un collage au moyen d'une colle ou encore d'une couche de scellement.

On pourra par ailleurs prévoir d'utiliser une couche d'adhésion entre la préforme et la structure à déformer ou encore utiliser des forces électrostatiques ou magnétiques pour maintenir en contact la préforme et la structure élémentaire courbée.

Encore une autre variante illustrée figure 9, consiste à mettre en vis à vis les deux structures 11 et 13 sans qu'elles soient collées et à les emboutir simultanément entre deux préformes respectivement concave 25 et convexe 26 de formes complémentaires. Les flèches sur la figure 9, illustrent les forces de pression à appliquer pour assurer la déformation. Les deux structures se déforment alors conjointement, un film d'air restant interposé entre les deux structures. Une fois atteinte la courbure désirée, le film d'air s'évacue du fait des forces appliquées, le collage par adhésion moléculaire s'effectue alors.

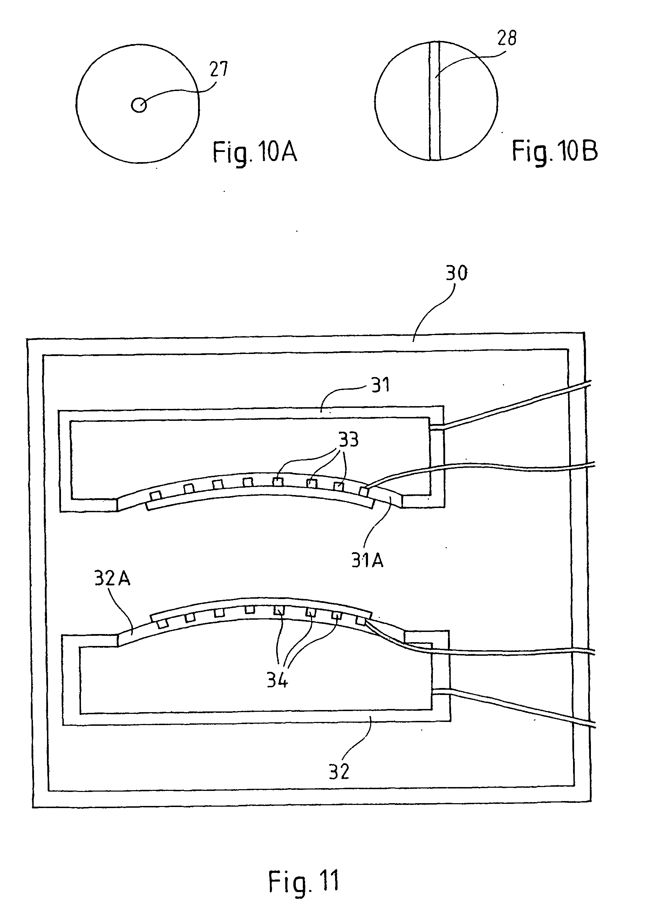

Lors de l'emboutissage de la deuxième structure 13 entre la première structure 11 et la préforme 14, une bulle d'air peut se trouver emprisonnée entre les deux structures et gêner le collage par adhésion moléculaire. Pour évacuer cette bulle d'air, on peut avantageusement prévoir de percer en leur centre 27, comme illustré figure 10A, l'une ou les deux structures à assembler par un perçage laser par exemple ou une gravure profonde de la structure.

Une alternative consiste à prévoir sur l'une ou les deux structures un ou plusieurs canaux d'évacuation 28 sur la face à assembler, débouchant en bordure de plaque comme illustré sur la figure 10B. Ces canaux peuvent, par exemple, avoir des dimensions de l'ordre de 100 µm de largeur et 5 µm de profondeur et être réalisés par les techniques usuelles de lithographie et de gravure. Des moyens d'aspiration pourront être associés à ces canaux 28 ou au perçage 27 pour faciliter l'évacuation de l'air emprisonné.

Une autre alternative peut consister à réaliser la déformation et l'assemblage sous un vide partiel afin de minimiser le volume d'air emprisonné. Cette méthode a l'inconvénient de nécessiter des vides d'autant plus poussés pour assurer la déformation des structures.

Une dernière alternative peut consister à placer des espaceurs en position radiale en périphérie de plaque, qui seront retirés une fois la zone centrale collée. Plus généralement, on pourra utiliser toute méthode qui permet d'initier le collage entre les deux structures en leurs centres pour ensuite le propager vers les bords. On peut pour cela par exemple introduire avant collage une légère différence de courbure entre les deux structures.

On obtient après collage selon le procédé de l'invention une structure complexe contrainte dont les contraintes sont connues en tout point et ce, en imposant une différence de contraintes tangentielles entre les faces des deux structures à assembler. Lorsqu'on supprime les forces qui ont permis de déformer les deux structures initiales (pression mécanique ou aspiration par le vide), avec la libération des faces extérieures de la structure complexe, les contraintes au sein de cette structure évoluent mais ce, de façon déterminée et connue de l'homme du métier. Cette évolution est fonction, entre autre, des natures et des épaisseurs des différents matériaux constituant chacune des deux structures initiales et de la différence de contraintes présente à l'interface de collage.

Les procédés décrits précédemment permettent la dissociation sous contraintes contrôlées d'une hétérostructure formée de substrats de matériaux différents. Ces substrats peuvent être plus ou moins épais, simples ou composites (formés d'un empilement de différentes couches de matériaux plus ou moins minces) processés ou non. Les matériaux concernés sont tous les semi-conducteurs comme notamment le silicium, le germanium, leurs alliages (Si₁₋ₓ Geₓ), le phosphure d'indium (InP), l'arsenic de gallium (GaAs), le niobate de lithium, le carbure de silicium (SiC), le nitrure de gallium (GaN), le saphir, les supraconducteurs comme par exemple les composés de type YbaCuO, NbN, ou BiSrCaCuO, tous les isolants comme notamment, la silice fondue, le quartz, les verres de différentes compositions, MgO, tous les métaux comme notamment le tungstène, le cuivre ou l'aluminium.

Diverses variantes de ce qui précède sont possibles.

Les préformes peuvent être chauffées pour permettre un collage en température des structures intermédiaires déformées. Avantageusement, les préformes peuvent ne pas être à la même température pour que les deux structures intermédiaires présentent une différence de température au moment de l'assemblage.

Le fait de coller les structures intermédiaires en température permet aussi de contrôler les contraintes internes de la structure complexe en plus du contrôle déjà permis par la déformation contrôlée des structures intermédiaires.

Il est alors, par exemple, possible d'annuler des contraintes internes d'une structure complexe à une température donnée en limitant la déformation des structures intermédiaires. Par exemple, on ne veut pas déformer à plus de 1,4m de rayon de courbure les deux structures intermédiaires constituées d'une plaque de silicium de 750 µm d'épaisseur et de 200 mm de diamètre et d'une plaque de silice fondue de 1200 µm d'épaisseur et de 200 mm de diamètre. Ces deux structures intermédiaires déformées à environ 1,4 m avant collage donnent une structure complexe où les contraintes internes sont annulées en environ 300°C si le collage a eu lieu à 20°C. En revanche, si on colle les deux structures intermédiaires à 100°C, les contraintes internes de la structure complexe s'annuleront à 380°C, donc à une température plus haute sans avoir à déformer de façon plus importante les structures intermédiaires.

On peut disposer entre les deux structures intermédiaires une couche qui flue à une certaine température, Tf. Le fait d'introduire cette couche de fluage permet de modifier les contraintes internes au sein de la structure complexe si la température du traitement thermique dépasse Tf.

Cela permet par exemple de minimiser des contraintes lors d'un recuit. Considérons par exemple une structure complexe constitué d'un substrat de silice fondue de 1200 µm d'épaisseur et de 200 mm de diamètre sur lequel on a un film de 0,4 µm de silicium. Le fait de créer la structure complexe avec l'invention permet de pouvoir atteindre une température de traitement thermique, Ttth, par exemple 800°C sans dépasser le niveau de contrainte que l'on s'est fixé pour conserver une bonne qualité cristalline au film de silicium (sans précontraindre les structures élémentaires pour former la structure complexe, on ne pouvait pas atteindre 800°C sans abîmer le film de silicium). En revanche, si on veut augmenter la température du traitement thermique sans modifier la déformation des structures élémentaires utilisée pour obtenir la structure complexe, on risque alors de dépasser le niveau de contrainte que l'on s'est fixé. Si on dispose d'une couche qui flue à Tf, avec Tf égale par exemple à 800°C, dès que la température de traitement thermique va dépasser Tf, la couche de fluage va fluer, relaxant ainsi une partie des contraintes internes. On peut alors effectuer un traitement thermique à une température supérieure à Ttth sans dépasser le niveau de contrainte interne que l'on s'est fixé.

Les préformes peuvent être des moules, par exemple des moules poreux.

Lorsque l'on utilise un système de différence de pression pour déformer les structures élémentaires ou maintenir les structures élémentaires sur les préformes, il peut être avantageux qu'une des faces des structures élémentaires ne soit pas à la pression atmosphérique mais à une pression différente, avantageusement supérieure. La figure 11 représente à titre d'exemple une enceinte 30 contenant deux préformes 31 et 32 comportant chacune une membrane déformable 31A ou 32A. A la surface de ces membranes débouchent des canaux d'aspiration 33 et 34, ici schématisés comme étant tangentiels. Les circuits d'aspiration ou de mise sous pression sont schématisés par de simples double traits.

Les canaux d'aspiration permettent de maintenir les structures élémentaires déformées ; on peut limiter la surface des canaux d'aspiration en soumettant la face libre de la structure intermédiaire à une pression supérieure à la pression atmosphérique (par exemple 200 kPa (2 bar) à l'intérieur de l'enceinte). Par ailleurs, si cette préforme déformable est déformée par une différence de pression, on peut atteindre une déformation plus importante en augmentant la pression sur la face libre de la structure élémentaire. A titre d'exemple, la préforme 31 est à une pression interne de 1,5 bar tandis que les canaux 33 sont à une pression de 304 Pa (0,3 bar); la préforme 32 est à une pression interne de 2,5 bar tandis que les canaux 34 sont à une pression de 30 kPa (0,3 bar). La pression de l'enceinte (200 kPa) est intermédiaire entre les pressions des préformes 31 et 32.

## Revendications

1. Procédé de réalisation d'une structure complexe par assemblage de deux substrats (5, 6 ; 11, 13) par deux faces respectives de liaison, cette structure étant destinée à être dissociée au niveau d'une zone de séparation, **caractérisé en ce que**, avant assemblage, on crée une différence d'état de contraintes tangentielles entre les deux faces à assembler en courbant chacun des deux substrats à assembler par application de forces mécaniques, cette différence étant choisie en sorte d'obtenir au sein de la structure assemblée un état de contraintes prédéterminé au moment de la dissociation.

2. Procédé de réalisation d'une structure complexe selon la revendication 1, **caractérisé en ce que** la différence d'état de contraintes tangentielles entre les deux faces à assembler est choisie en sorte de minimiser les contraintes au niveau de la zone de séparation au moment de cette dissociation.

3. Procédé de réalisation d'une structure complexe selon la revendication 1 ou la revendication 2, **caractérisé en ce que** les deux substrats sont courbés de sorte que les deux faces à assembler soient respectivement concave et convexe.

4. Procédé de réalisation d'une structure complexe selon la revendication 3, **caractérisé en ce que** les deux substrats sont courbés de sorte que les deux faces à assembler soient complémentaires.

5. Procédé de réalisation d'une structure complexe selon la revendication 4, **caractérisé en ce que** les deux substrats sont courbés de sorte que les deux faces à assembler soient respectivement sphérique concave et sphérique convexe.

6. Procédé de réalisation d'une structure complexe selon l'une quelconque des revendications 1 à 5, **caractérisé en ce que** les forces mécaniques appliquées sur le substrat résultent de la création d'une différence de pression entre les deux faces dudit substrat.

7. Procédé de réalisation d'une structure complexe selon la revendication 6, **caractérisé en ce que** la différence de pression entre les deux faces du substrat à courber pour qu'il présente une face à assembler concave est créée par aspiration dudit substrat sur une préforme concave de profil adapté choisi en fonction de celui à donner à la face à assembler et sur laquelle le substrat repose localement en sa périphérie.

8. Procédé de réalisation d'une structure complexe selon la revendication 6, **caractérisé en ce que** la différence de pression entre les deux faces du substrat à courber pour qu'il présente une face à assembler concave est créée par aspiration dudit substrat à l'intérieur d'une cavité, le substrat reposant localement en sa périphérie sur un joint bordant la cavité.

9. Procédé de réalisation d'une structure complexe l'une quelconque des revendications 1 à 5, **caractérisé en ce que** les forces mécaniques appliquées sur le substrat résultent de la déformation de ce substrat entre une première et une deuxième préformes complémentaires, l'une concave, l'autre convexe de profils choisis en fonction de celui à donner à la face à assembler.

10. Procédé de réalisation d'une structure complexe selon la revendication 9, **caractérisé en ce que** la première préforme est un des substrats à assembler déjà courbé selon la profil désiré

11. Procédé de réalisation d'une structure complexe selon la revendication 9 ou la revendication 10, **caractérisé en ce que** la deuxième préforme est munie de canaux d'aspiration pour maintenir le substrat courbé une fois enlevée la première préforme.

12. Procédé de réalisation d'une structure complexe selon l'une quelconque des revendications 1 à 5, **caractérisé en ce que** les forces mécaniques sont appliquées simultanément sur les deux substrats à assembler par déformation des deux substrats entre deux préformes de profits choisis en fonction de ceux à donner aux faces à assembler.

13. Procédé de réalisation d'une structure complexe selon l'une quelconque des revendications 1 à 12, **caractérisé en ce que** l'application de forces mécaniques sur l'un au moins des substrats est effectuée à l'aide d'une préforme constituée d'un moule.

14. Procédé de réalisation d'une structure complexe selon la revendication 13, **caractérisé en ce que** cette préforme est constituée d'un moule poreux.

15. Procédé de réalisation d'une structure complexe selon l'une quelconque des revendications 1 à 12, **caractérisé en ce que** l'application de forces mécaniques sur les substrats est effectuée à l'aide d'au moins une préforme déformable.

16. Procédé de réalisation d'une structure complexe selon l'une quelconque des revendications 1 à 15, **caractérisé en ce que** l'assemblage entre les deux substrats est un collage moléculaire.

17. Procédé de réalisation d'une structure complexe selon l'une quelconque des revendications 1 à 15, **caractérisé en ce que** les deux faces à assembler sont traitées afin de faciliter le collage.

18. Procédé de réalisation d'une structure complexe selon l'une quelconque des revendication 1 à 17, **caractérisé en ce que** l'assemblage entre les substrats est réalisé par contact direct, la surface d'au moins l'un des substrats étant aménagée en sorte d'éviter un plégeage d'air entre les surfaces assemblées.

19. Procédé de réalisation d'une structure complexe selon la revendication 18, **caractérisé en ce que** l'un au moins des substrats est percé.

20. Procédé de réalisation d'une structure complexe selon la revendication 19, **caractérisé en ce que** ce substrat est percé en son centre.

21. Procédé de réalisation d'une structure complexe selon la revendication 18, **caractérisé en ce que** l'un au moins des substrats comporte au moins un canal non traversant débouchant en bordure du substrat.

22. Procédé de réalisation d'une structure complexe selon l'une quelconque des revendications 1 à 15, **caractérisé en ce que** l'assemblage entre les substrats est réalisé au moyen d'une couche de fluage.

23. Procédé de réalisation d'une structure complexe selon l'une quelconque des revendications 1 à 22. **caractérisé en ce qu'**on réalise l'assemblage à une température supérieure à l'ambiante.

24. Procédé de réalisation d'une structure complexe selon la revendication 23, **caractérisé en ce que** les substrats sont chauffés par contact avec des préformes chauffées.

25. Procédé de réalisation d'une structure complexe selon la revendication 24, **caractérisé en ce que** les préformes sont respectivement chauffées à des températures différentes.

26. Procédé de report d'une couche mince depuis un substrat source vers un substrat cible, comprenant les étapes suivantes :
- Implantation ionique au travers d'une face du substrat source pour créer une couche fragilisée enterrée à une profondeur déterminée par rapport à la face implantée du substrat source, une couche mince étant ainsi délimitée entre la face implantée et la couche enterrée.
- assemblage d'une face du substrat source sur une face du substrat cible pour former une structure assemblée
- dissociation de la couche mince d'avec le reste du substrat source au niveau de la couche enterrée,
**caractérisé en ce que**, avant assemblage, on crée une différence d'état de contraintes tangentielles entre les deux faces à assembler en courbant chacun des deux substrats à assembler par application de forces mécaniques, cette différence étant choisie en sorte d'obtenir au sein de la structure assemblée un état de contraintes prédéterminé au moment de la dissociation.

27. Procédé de report d'une couche mince selon la revendication 26, **caractérisé en ce que** la différence d'état de contraintes tangentielles entre les deux faces à assembler est choisie en sorte de minimiser les contraintes internes au moment de la dissociation.

## Claims

1. Method of producing a complex structure by assembling two substrates (5, 6; 11, 13) by two respective connecting faces, the structure being adapted to be dissociated in a separation region, **characterized in that**, prior to assembly, a tangential stress state difference is created between the two faces to be assembled by curving each of the two substrates to be assembled by applying mechanical forces, this difference being selected to obtain a predetermined stress state within the assembled structure at the moment of dissociation.

2. Method according to claim 1 of producing a complex structure, **characterized in that** the tangential stress state difference between the two faces to be assembled is selected to minimize the stresses in the separation region at the moment of said dissociation.

3. Method according to claim 1 or claim 2 of producing a complex structure, **characterized in that** the two substrates are curved so that the two faces to be assembled are respectively concave and convex.

4. Method according to claim 3 of producing a complex structure, **characterized in that** the two substrates are curved so that the two faces to be assembled are complementary.

5. Method according to claim 4 of producing a complex structure, **characterized in that** the two substrates are curved so that the two faces to be assembled are respectively spherical concave and spherical convex.

6. Method according to any one of claims 1 to 5 of producing a complex structure, **characterized in that** the mechanical forces applied to the substrate result from the creation of a pressure difference between the two faces of said substrate.

7. Method according to claim 6 of producing a complex structure, **characterized in that** the pressure difference between the two faces of the substrate to be curved so that it has a concave face to be assembled is created by aspirating said substrate onto a concave preform having a suitable profile selected as a function of that to be imparted to the face to be assembled and on which the substrate rests locally at its periphery.

8. Method according to claim 6 of producing a complex structure, **characterized in that** the pressure difference between the two faces of the substrate to be curved so that it has a concave face to be assembled is created by aspirating said substrate into a cavity, the substrate resting locally at its periphery on a seal bordering the cavity.

9. Method according to any one of claims 1 to 5 of producing a complex structure, **characterized in that** the mechanical forces applied to the substrate are the result of deforming the substrate between complementary first and second preforms, one of which is concave and the other of which is convex, with profiles selected as a function of that to be imparted to the face to be assembled.

10. Method according to claim 9 of producing a complex structure, **characterized in that** the first preform is one of the substrates to be assembled that has already been curved to the selected profile.

11. Method according to claim 9 or claim 10 of producing a complex structure, **characterized in that** the second preform has aspiration channels for keeping the substrate curved when the first preform has been removed.

12. Method according to any one of claims 1 to 5 of producing a complex structure, **characterized in that** the mechanical forces are applied simultaneously to the two substrates to be assembled by deforming the two substrates between two preforms having profiles selected as a function of those to be imparted to the faces to be assembled.

13. Method according to any one of claims 1 to 12 of producing a complex structure, **characterized in that** mechanical forces are applied to at least one of the substrates by means of a preform consisting of a mold.

14. Method according to claim 13 of producing a complex structure, **characterized in that** said preform consists of a porous mold.

15. Method according to any one of claims 1 to 12 of producing a complex structure, **characterized in that** mechanical forces are applied to the substrates with the aid of at least one deformable preform.

16. Method according to any one of claims 1 to 15 of producing a complex structure, **characterized in that** the two substrates are assembled by molecular bonding.

17. Method according to any one of claims 1 to 15 of producing a complex structure, **characterized in that** the two faces to be assembled are treated to facilitate bonding.

18. Method according to any one of claims 1 to 17 of producing a complex structure, **characterized in that** the substrates are assembled by direct contact, the surface of at least one of the substrates being adapted to avoid trapping of air between the assembled surfaces.

19. Method according to claim 18 of producing a complex structure, **characterized in that** at least one of the substrates is pierced.

20. Method according to claim 19 of producing a complex structure, **characterized in that** said substrate is pierced at its center.

21. Method according to claim 18 of producing a complex structure, **characterized in that** at least one of the substrates includes at least one dead-end channel discharging at the edge of the substrate.

22. Method according to any one of claims 1 to 15 of producing a complex structure, **characterized in that** the substrates are assembled by means of a flow layer.

23. Method according to any one of claims 1 to 22 of producing a complex structure, **characterized in that** assembly is carried out at a temperature higher than room temperature.

24. Method according to claim 23 of producing a complex structure, **characterized in that** the substrates are heated by contact with heated preforms.

25. Method according to claim 24 of producing a complex structure, **characterized in that** the preforms are respectively heated to different temperatures.

26. Method for transferring a thin layer from a source substrate to a target substrate, comprising the following steps:
- ionically implanting the source substrate through one face thereof to create a buried weakened layer at a particular depth relative to the implanted face of the source substrate, a thin layer thereby being delimited between the implanted face and the buried layer,
- assembling one face of the source substrate to one face of the target substrate to form an assembled structure,
- dissociating the thin layer from the remainder of the source substrate in the buried layer,
**characterized in that**, prior to assembly, a tangential stress state difference is created between the two faces to be assembled by curving each of the two substrates to be assembled by applying mechanical forces, this difference being selected to obtain within the assembled structure a predetermined stress state at the moment of dissociation.

27. Method according to claim 26 of transferring a thin layer, **characterized in that** the tangential stress state difference between the two faces to be assembled is selected to minimize the internal stresses at the moment of dissociation.

## Patentansprüche

1. Verfahren für die Herstellung einer komplexen Struktur durch Zusammenfügen zweier Substrate (5, 6; 11, 13) an zwei entsprechenden Verbindungsflächen, wobei diese Struktur dazu vorgesehen ist, auf Höhe einer Trennzone getrennt zu werden, **dadurch gekennzeichnet, dass** vor dem Zusammenfügen eine Zustandsdifferenz tangentialer Beanspruchungen zwischen den zwei zusammenzufügenden Flächen erzeugt wird, indem jedes der zwei zusammenzufügenden Substrate durch Ausüben mechanischer Kräfte gebogen wird, wobei diese Differenz in der Weise gewählt wird, dass innerhalb der zusammengefügten Struktur zum Zeitpunkt der Trennung ein vorgegebener Beanspruchungszustand erhalten wird.

2. Verfahren für die Herstellung einer komplexen Struktur nach Anspruch 1, **dadurch gekennzeichnet, dass** die Zustandsdifferenz tangentialer Beanspruchungen zwischen den zwei zusammenzufügenden Flächen in der Weise gewählt wird, dass die Beanspruchungen auf Höhe der Trennzone zum Zeitpunkt dieser Trennung minimal sind.

3. Verfahren für die Herstellung einer komplexen Struktur nach Anspruch 1 oder Anspruch 2, **dadurch gekennzeichnet, dass** die zwei Substrate in der Weise gebogen werden, dass die zwei zusammenzufügenden Flächen konkav bzw. konvex sind.

4. Verfahren für die Herstellung einer komplexen Struktur nach Anspruch 3, **dadurch gekennzeichnet, dass** die zwei Substrate in der Weise gebogen werden, dass die zusammenzufügenden Flächen komplementär sind.

5. Verfahren für die Herstellung einer komplexen Struktur nach Anspruch 4, **dadurch gekennzeichnet, dass** die zwei Substrate in der Weise gebogen werden, dass die zwei zusammenzufügenden Flächen sphärisch konkav bzw. sphärisch konvex sind.

6. Verfahren für die Herstellung einer komplexen Struktur nach einem der Ansprüche 1 bis 5, **dadurch gekennzeichnet, dass** sich die auf das Substrat ausgeübten mechanischen Kräfte aus der Erzeugung einer Druckdifferenz zwischen den zwei Flächen des Substrats ergeben.

7. Verfahren für die Herstellung einer komplexen Struktur nach Anspruch 6, **dadurch gekennzeichnet, dass** die Druckdifferenz zwischen den zwei Flächen des zu biegenden Substrats, damit es eine konkave zusammenzufügende Fläche aufweist, durch Ansaugen des Substrats gegen eine konkave Vorform mit angepasstem Profil erzeugt wird, das in Abhängigkeit von jenem gewählt ist, das der zusammenzufügenden Fläche verliehen werden soll, und auf der das Substrat an seinem Umfang lokal aufliegt.

8. Verfahren für die Herstellung einer komplexen Struktur nach Anspruch 6, **dadurch gekennzeichnet, dass** die Druckdifferenz zwischen den zwei Flächen des zu biegenden Substrats, damit es eine konkave zusammenzufügende Fläche aufweist, durch Ansaugen des Substrats in einem Hohlraum erzeugt wird, wobei das Substrat lokal an seinem Umfang an einer den Hohlraum begrenzenden Verbindungslinie aufliegt.

9. Verfahren für die Herstellung einer komplexen Struktur nach einem der Ansprüche 1 bis 5, **dadurch gekennzeichnet, dass** sich die auf das Substrat ausgeübten mechanischen Kräfte aus der Verformung dieses Substrats zwischen einer ersten und einer zweiten komplementären Vorform ergeben, wovon die eine ein konkaves und die andere ein konvexes Profil hat, die in Abhängigkeit von jenem Profil gewählt sind, das der zusammenzufügenden Fläche verliehen werden soll.

10. Verfahren für die Herstellung einer komplexen Struktur nach Anspruch 9, **dadurch gekennzeichnet, dass** die erste Vorform eines der zusammenzufügenden Substrate ist, das bereits gemäß dem gewünschten Profil gebogen ist.

11. Verfahren für die Herstellung einer komplexen Struktur nach Anspruch 9 oder Anspruch 10, **dadurch gekennzeichnet, dass** die zweite Vorform mit Ansaugkanälen versehen ist, um das Substrat gebogen zu halten, sobald es von der ersten Vorform abgehoben worden ist.

12. Verfahren für die Herstellung einer komplexen Struktur nach einem der Ansprüche 1 bis 5, **dadurch gekennzeichnet, dass** die mechanischen Kräfte gleichzeitig auf die zwei zusammenzufügenden Substrate durch Verformen der zwei Substrate zwischen zwei Vorformen mit Profilen, die in Abhängigkeit von jenen gewählt sind, die den zusammenzufügenden Flächen verliehen werden sollen, ausgeübt werden.

13. Verfahren für die Herstellung einer komplexen Struktur nach einem der Ansprüche 1 bis 12, **dadurch gekennzeichnet, dass** die Ausübung mechanischer Kräfte auf wenigstens eines der Substrate mit Hilfe einer durch eine Gießform gebildeten Vorform ausgeführt wird.

14. Verfahren für die Herstellung einer komplexen Struktur nach Anspruch 13, **dadurch gekennzeichnet, dass** diese Vorform aus einer porösen Gießform gebildet ist.

15. Verfahren für die Herstellung einer komplexen Struktur nach einem der Ansprüche 1 bis 12, **dadurch gekennzeichnet, dass** die Ausübung mechanischer Kräfte auf die Substrate mit Hilfe wenigstens einer verformbaren Vorform ausgeführt wird.

16. Verfahren für die Herstellung einer komplexen Struktur nach einem der Ansprüche 1 bis 15, **dadurch gekennzeichnet, dass** die Zusammenfügung zwischen den zwei Substraten eine molekulare Klebung ist.

17. Verfahren für die Herstellung einer komplexen Struktur nach einem der Ansprüche 1 bis 15, **dadurch gekennzeichnet, dass** die zwei zusammenzufügenden Flächen behandelt werden, um das Kleben zu erleichtern.

18. Verfahren für die Herstellung einer komplexen Struktur nach einem der Ansprüche 1 bis 17, **dadurch gekennzeichnet, dass** die Zusammenfügung zwischen den Substraten durch direkten Kontakt erfolgt, wobei die Oberfläche wenigstens eines der Substrate so zugerichtet wird, dass eine Bewegung (plégeage) von Luft zwischen den zusammengefügten Oberflächen verhindert wird.

19. Verfahren für die Herstellung einer komplexen Struktur nach Anspruch 18, **dadurch gekennzeichnet, dass** wenigstens eines der Substrate durchlocht ist.

20. Verfahren für die Herstellung einer komplexen Struktur nach Anspruch 19, **dadurch gekennzeichnet, dass** dieses Substrat in seinem Zentrum durchlocht ist.

21. Verfahren für die Herstellung einer komplexen Struktur nach Anspruch 18, **dadurch gekennzeichnet, dass** wenigstens eines der Substrate wenigstens einen nicht durchgehenden Kanal aufweist, der in den Rand des Substrats mündet.

22. Verfahren für die Herstellung einer komplexen Struktur nach einem der Ansprüche 1 bis 15, **dadurch gekennzeichnet, dass** die Zusammenfügung zwischen den Substraten mittels einer Kriechschicht verwirklicht wird.

23. Verfahren für die Herstellung einer komplexen Struktur nach einem der Ansprüche 1 bis 22, **dadurch gekennzeichnet, dass** die Zusammenfügung bei einer Temperatur, die höher als die Umgebungstemperatur ist, ausgeführt wird.

24. Verfahren für die Herstellung einer komplexen Struktur nach Anspruch 23, **dadurch gekennzeichnet, dass** die Substrate durch Kontakt mit erwärmten Vorformen erwärmt werden.

25. Verfahren für die Herstellung einer komplexen Struktur nach Anspruch 24, **dadurch gekennzeichnet, dass** die Vorformen jeweils auf unterschiedliche Temperaturen erwärmt werden.

26. Verfahren zum Übertragen einer Dünnschicht von einem Ausgangssubstrat zu einem Zielsubstrat, das die folgenden Schritte umfasst:
- Ionenimplantation durch eine Fläche des Ausgangssubstrats, um eine versprödete Schicht zu erzeugen, die auf einer vorgegebenen Tiefe in Bezug auf die implantierte Fläche des Ausgangssubstrats vergraben ist, wodurch zwischen der implantierten Fläche und der vergrabenen Schicht eine Dünnschicht begrenzt wird,
- Zusammenfügen einer Fläche des Ausgangssubstrats mit einer Fläche des Zielsubstrats, um eine zusammengefügte Struktur zu bilden,
- Trennen der Dünnschicht mit dem Rest des Ausgangssubstrats auf Höhe der vergrabenen Schicht,
**dadurch gekennzeichnet, dass** vor dem Zusammenfügen eine Zustandsdifferenz tangentialer Beanspruchungen zwischen den zwei zusammenzufügenden Flächen erzeugt wird, indem jedes der zwei zusammenzufügenden Substrate durch Ausüben mechanischer Kräfte gebogen wird, wobei diese Differenz so gewählt wird, dass innerhalb der zusammengefügten Struktur zum Zeitpunkt des Trennens ein vorgegebener Beanspruchungszustand erhalten wird.

27. Verfahren zum Übertragen einer Dünnschicht nach Anspruch 26, **dadurch gekennzeichnet, dass** die Zustandsdifferenz der tangentialen Beanspruchungen zwischen den zwei zusammenzufügenden Flächen in der Weise gewählt wird, dass die internen Beanspruchungen zum Zeitpunkt der Trennung minimal sind.
